Europäisches Patentamt

European Patent Office

Office européen des brevets

(11) Publication number: **0 226 949 B1**

# EUROPEAN PATENT SPECIFICATION

(45) Date of publication of patent specification: **05.08.92**　(51) Int. Cl.5: **H01L 21/00, G01N 19/04**

(21) Application number: **86117185.8**

(22) Date of filing: **10.12.86**

(54) **Control apparatus for adhesive force of adhesive agent adhering between semiconductor wafer and substrate.**

(30) Priority: **12.12.85 JP 190304/85 U**
　　　　　**04.11.86 JP 168197/86 U**

(43) Date of publication of application:
**01.07.87 Bulletin 87/27**

(45) Publication of the grant of the patent:
**05.08.92 Bulletin 92/32**

(84) Designated Contracting States:
**DE FR GB NL**

(56) References cited:
**DE-A- 2 558 963**
**US-A- 3 968 885**

**PATENT ABSTRACTS OF JAPAN, vol. 8, no. 250 (E-279)[1687], 16th November 1984, page 90 E 279; & JP-A-59 126 648**

(73) Proprietor: **LINTEC KABUSHIKI KAISHA**
**No. 23-23, Hon-cho Itabashi-ku**
**Tokyo(JP)**

(72) Inventor: **Irie, Eiichi**
**No. 1-13-7, Sakae Washimiya-machi**
**Kitakatsushika-gun Saitama-ken(JP)**

(74) Representative: **Schmidt-Evers, Jürgen, Dipl.-Ing. et al**
**Patentanwälte Dipl.-Ing. H. Mitscherlich**
**Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10**
**W-8000 München 22(DE)**

EP 0 226 949 B1

# Description

This invention relates to a control apparatus for reducing the adhesive force of an adhesive agent in order that a semiconductor wafer such as a silicon wafer or the like adhered to a substrate such as a synthetic resin film or the like may be taken off from the sheet.

It has been hitherto known that, after a semiconductor wafer is applied with a circuit forming treatment, such as etching or the like, so that IC circuits are formed thereon, the wafer is adhered with an adhesive agent to a substrate such as a synthetic resin film or the like so that a workpiece may be formed, and the wafer thereof is cut into IC chips, and thereafter each chip is taken off from the substrate so as to be mounted in a package. In this case, each chip taken off therefrom is desirable not to be brought into such a contaminated condition that part of the adhesive agent is transferred to a rear surface thereof. It has been proposed for this purpose that, as disclosed in Japanese Patent Application Publication Sho 58 - 50164, there is used as the adhesive agent a photo-setting type one. The photo-setting adhesive agent is hardened or cured with a resulting decrease in its adhesive force, by irradiating a light thereonto after cutting the wafer into IC chips, and thereby it can be prevented that the adhesive agent is transferred to the rear surface of each chip when the chip is taken off from the substrate. A similar process is disclosed in JP-A-59 126648.

Additionally, it is known to use a cassette casing containing a plurality of the workpieces, and each workpiece after taken out, one by one, from the casing is subjected to the foregoing photo-setting treatment of the adhesive agent thereof, and thereafter is conveyed into an empty cassette casing for being conveyed to the next treating step.

In this case, the time of irradiation of light thereon required for sufficiently reducing the adhesive force of the photo-setting adhesive agent of the workpiece is above 10 seconds, even in a case where the adhesive agent has a quick hardening property, and this period of time is too long as a photo-setting treatment time for the IC manufacturing process and is not desirable.

A purpose of this invention is to provide an apparatus suitable for shortening the required time for irradiating of a light onto the workpiece.

In addition, it is desirable for improving the efficiency of such a photo-setting treatment of plural workpieces such that those workpieces contained in the cassette casing are taken out one by one automatically and,after being subjected to the foregoing photo-setting treatment, are placed into the other cassette casing one by one automatically.

Another purpose of this invention is to provide an apparatus which can meet this desire and can perform the foregoing photo-setting treatment automatically.

According to the invention as claimed, there is provided an apparatus comprising such a treating container having a light transmissive window and a closure member for opening and closing the container that is to be charged with a workpiece formed by adhering a semiconductor wafer through a photo-setting adhesive agent, to a light transmissive substrate such as a light transmissive synthetic resin, sheet, film or the like, and a light source such as a mercury vapor lamp or the like located opposite to the foregoing light transmissive window, and a deoxygenating means for removing internal atmospheric air from the container is connected to the container.

Next, the operation of this invention apparatus will be explained as follows:-

If a step for forming a large number of IC circuits on the surface of the semiconductor of the workpiece is completed, the wafer is cut into chips for respective IC circuits, and each chip is taken off from the substrate and is mounted in a package. In this case, the wafer is adhered to the substrate such as a light transmission synthetic resin sheet, film or the like through the adhesive agent, and therefore prior to taking off those chips from the substrate, the workpiece is applied with such a treatment that the adhesive agent thereof is irradiated by a light, so that the adhesive force thereof is decreased.

This photo-setting treatment is carried out in such a manner that the workpiece is charged into the opened container and the container is closed by the closure member thereof, the internal atmospheric air thereof is exchanged by nitrogen gas or the like introduced into the container so that the internal atmosphere is brought into the condition substantially not containing oxygen, and under the resultant deoxygenated condition, the adhesive agent thereof is irradiated by light from the light source through the light transmissive window of the container so that its adhesive force may be sufficiently decreased. Thereafter the external atmospheric air is introduced into the container, the workpiece is taken out after the closure member thereof is opened. According to this treatment, the adhesive force can be sufficiently weakened by irradiating the light onto the adhesive agent only for about 1 second, and there is no adhesive agent transferred to the rear surface of each chip picked up from the substrate.

Additionally, according to another apparatus for the foregoing procedure, it is so arranged that plural workpieces are placed into the elevatable cassette casing so as to be oriented in the predetermined same direction, are taken out therefrom, one by one, through the charging conveyor to one lateral side of the container, and the workpieces thus taken out are charged, one by one, into the container by the sucker means of the charging arm. Thereafter the workpiece adhesive agent thereof in the closed container is applied with the photo-setting treatment in such a manner as above, and, after the completion of this photo-setting treatment, the workpiece is discharged from the container by the sucker means of the discharging arm to the discharging conveyor and is further conveyed into the elevatable empty cassette casing by the discharging conveyor.

Embodying examples of this invention will now be explained with reference to the accompanying drawings:-

BRIEF EXPLANATION OF THE DRAWING

Fig. 1 is a front view of an embodying example of this invention apparatus,

Fig. 2 is a top plan view thereof,

Fig. 3 is a right side view, partly in section, of the same,

Fig. 4 is a left side view of the same,

Fig. 5 is a perspective view of a cassette casing,

Fig. 6 is a perspective view, partly omitted, of a workpiece,

Fig. 7 is an enlarged sectional view of an important portion of the apparatus,

Fig. 8 is a front view of another embodying example of this invention apparatus,

Fig. 9 is a top plan view thereof,

Fig. 10 is a right side view, partly in section, of the same,

Fig. 11 is a left side view of the same,

Fig. 12 is a side view viewed from the line XII - XII in Fig. 8, and

Fig. 13 is a top plan view for explaining a conveying mode of a workpiece.

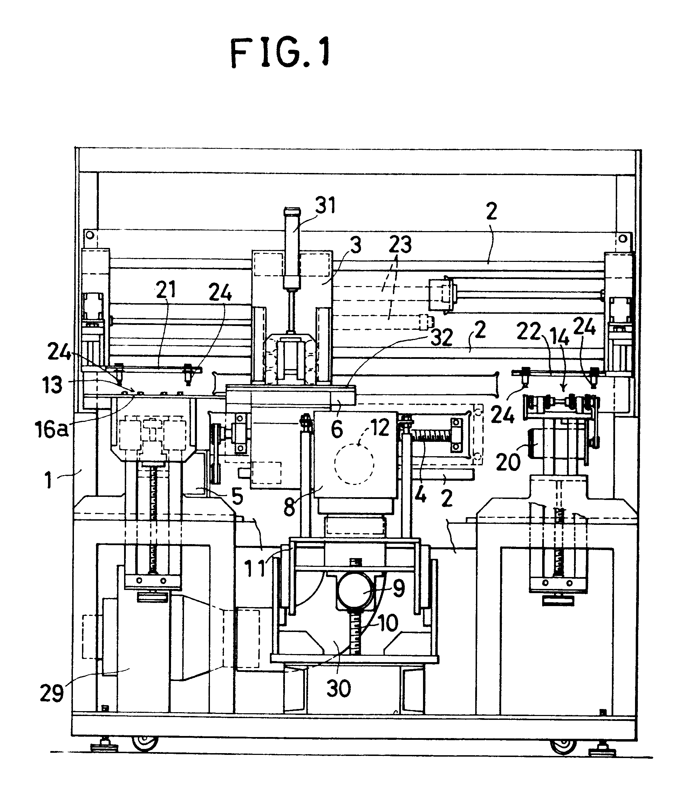

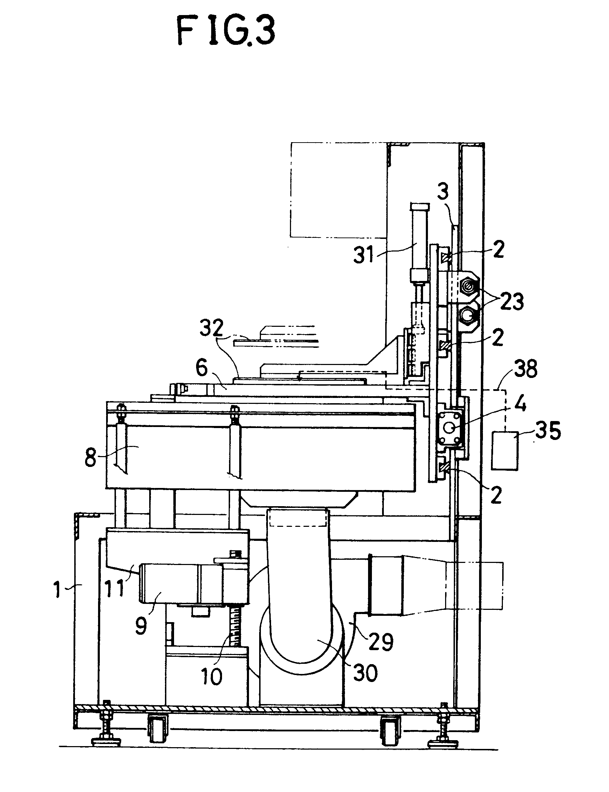

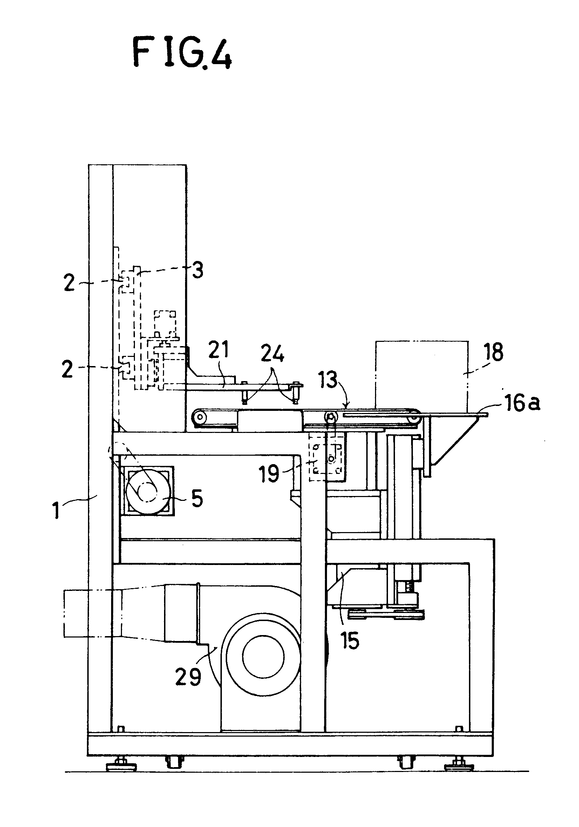

Referring to Figs. 1 - 4, numeral 1 denotes a machine frame of a control apparatus for decreasing an adhesive force, numerals 2, 2 denote a pair of upper and lower guide rods extending horizontally leftward and rightward at a rear section of the machine frame 1, numeral 3 denotes a movable plate which is movable rightward and leftward while being guided by the guide rods 2, 2, numeral 4 denotes a feeding screw for moving the movable plate 3, and numeral 5 denotes an electric motor for driving the feeding screw 4.

The movable plate 3 is provided with a treating container 6 horizontally extending forward therefrom so as to be integral therewith, and the machine frame 1 is provided beneath the container 6, with a light source 12 which is encased by a casing 8 and is attached to a base frame 11 which is movable upwards and downwards along a screw rod 10 by driving an electric motor 9.

Numeral 13 denotes a charging conveyer provided on one side of the light source 12, and numeral 14 denotes a discharging conveyor provided on the other side of the light source 12, and these conveyors 13, 14 are so arranged that one end portions thereof may be positioned adjacent to U-shaped end portions of working tables 16a, 16b which are movable upward and downward by pulse motors 15, 15.

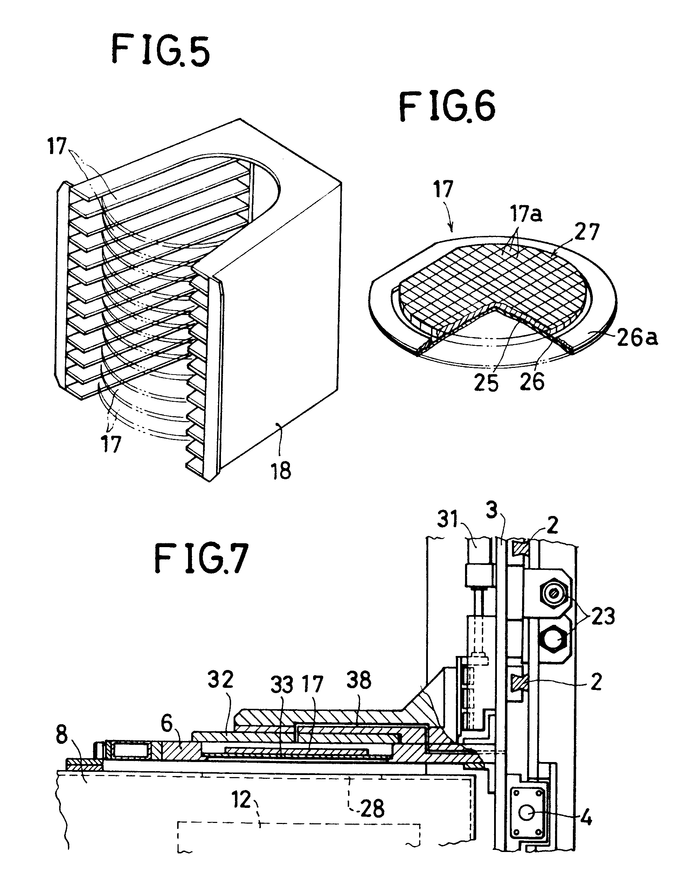

A cassette casing 18 having a large number of shelves and containing plural workpieces 17 resting on the respective shelves, as shown in Fig. 5, is mounted on the working table 16a mounted on the charging conveyor 13 so that when the work table 16a is lowered together with the cassette casing 18 and the lowermost workpiece 17 is placed on the charging conveyor 13, a driving motor 19 is operated to drive the conveyor 13 and thereby the workpiece 17 is drawn out from the cassette casing 18. The cassette casing 18 is lowered by one step at a proper time for the next drawing out operation.

An empty cassette casing 18, initially not containing any workpiece 17, is mounted on the work table 16b located adjacent to the discharging conveyer 14 so that when the workpiece 17 is placed on the discharging conveyer 14, a driving motor 20 as clearly shown in Fig. 1 is operated to drive the conveyor 14 and thereby the workpiece 17 is so conveyed into the empty cassette casing 18 as to be placed on the uppermost shelf thereof, and at the time of completion of this encasing operation, the work table 16 is elevated, by one step, together with the casing 18 by operation of the pulse motor 15 to be ready for the next encasing operation.

Numerals 21, 22 denote a charging arm and a discharging arm which are so arranged as to be given linear reciprocating movements along on the guide rods 2, 2 of the machine frame 1 by air cylinders 23, 23, and the charging arm 21 is so arranged that the workpiece 17 conveyed out from the cassette casing 18 by the charging conveyor 13 may be charged into the container 6, by a sucker means carrying sucker pads 24 provided on a lower surface thereof. On the other hand, the discharging arm 22 is so arranged as to serve to discharge the workpiece 17 from the container 6 onto the discharging conveyor by a sucker means 24 thereof.

These sucker means 24 are connected to proper suction control means not illustrated so that the attraction and release of the workpiece may be controlled properly for charging and discharging the workpiece into and out of the container.

The detail of the workpiece 17 is as shown clearly in Fig. 6. Namely, the same is prepared by such a manner that a semiconductor wafer 27 comprising a silicon wafer is adhered, through a photo-setting adhesive agent 25, to a circular substrate 26 made of a transparent synthetic resin, sheet, film or the like such as of vinyl chloride, polyethylene telephthalate, polypropylene or the like, and thereafter the wafer 27 is cut into chips 17a. As for the adhesive agent 25, there is used, for instance, one that is composed of an acrylic series adhesive agent of 10 - 90 weight parts and an urethane acrylate series olygomer of 90 - 10 weight parts, and is so hardened, through polymerization, as to be extremely weaken in its adhesive force by being irradiated by a light in a broad sense such as an ultraviolet ray from a mercury vapor lamp, an electron beam from an electron tube or the like. Numeral 26a denotes a SUS made flange panel adhered to a circumferential edge portion of the substrate 26 so that the workpiece 17 may be moved by such a way that the flange $26_a$ is sucked by the sucker pads of the respective sucker means 24, 24 of the charging arm 21 and the discharging arm 22.

In the illustrated example, a mercury vapor lamp of 80 W/cm is used for the light source 12 so that the same may serve to irradiate the bottom surface of the closed container 6 when the container 6 goes across over a slit 28 made in an upper portion of the casing 8 encasing the light source 12. An electron beam generating means may be used for the light source 12. Numeral 29 denotes a cooling fan for the light source 12, and numeral 30 denotes a cooling duct.

As shown clearly in Fig. 7, the treating container 6 is provided, on its upper side, with a closure member 32 which can open and close the container 6 by being moved upward and downward by a cylinder 31 provided on the movable plate 3, and is provided, on its bottom portion, with a light transmissive window 33 which is to face the light source 12. The light transmissive window 33 comprises an ultraviolet ray transmissive glass pane if the light source 12 is a mercury vapor lamp, and the same is a Be made window pane if the light source 12 is an electron beam generating means.

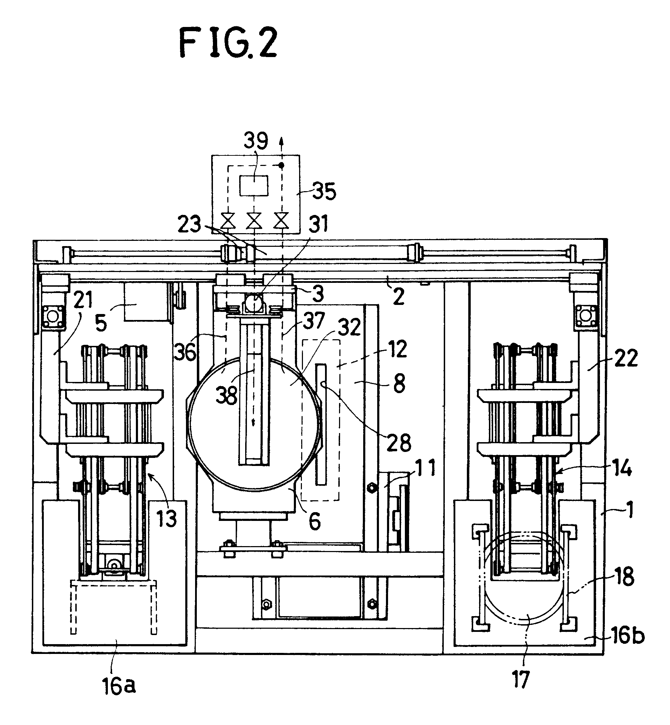

A deaerating or deoxygenating means 35 is composed of passages 36, 37 38 and a nitrogen gas source 39. More in detail, as shown in Fig. 2, the passages 36, 37, 38 connected to the deoxygenating means 35 are made in the closure member 32, so that if the passages 36, 37 are opened to the external atmosphere and the nitrogen gas is introduced into the closed container 6 through the passage 38 from the nitrogen gas source 39, the air in the container 6 is replaced with the nitrogen gas and there is established such an atmosphere free from oxygen.

As for the deoxygenating means 35 for removing the internal atmospheric air from the container 6, such a modified one may be considered that the internal atmospheric air of the container 6 may be evacuated by a vacuum pump (not shown). In this case, the closure member 32 and the light window 33 in relation to the container body have to be constructed to be made so airtight as to prevent the external air from entering therethrough.

However, this results in an increase in manufacturing cost. Accordingly, if such an arrangement as shown in the illustrated example that the internal atmospheric air of the container 6 is expelled by the introduced nitrogen gas is adopted, an airtightness for the container 6 can be eased to lower manufacturing costs.

Such a modification can be that the oxygen is removed by introducing any other kind of inert gas than the nitrogen gas into the container 6, and a further modified deoxygenating means is such that, after the internal atmospheric air of the container 6 is once evacuated by an evacuation pump, an inert gas or the like is introduced thereinto, so that there is established an atmosphere not including oxygen in the container 6.

If there is established such an internal atmospheric condition that the content of oxygen of the atmosphere in the container 6 is below about 1 %, the adhesive agent 25 of the workpiece 17 can be hardened by a light irradiating thereonto through the substrate 26, to reduce its adhesive force, and at the same time each chip 17a formed by cutting the wafer 27 can be taken off from the substrate 26 by a slight force, and no adhesive agent 25 is left remaining on the rear surface of the chip 17a. Id

The operation of the apparatus shown in Figs. 1 - 4 is as follows:-

Firstly, a cassette casing 18 containing plural workpieces 17 resting on the respective shelves under such a condition that the wafers 27 of each of the workpieces 17 are directed upwards is placed on the working table 16a located adjacent to the charging conveyor 13, and, on the other hand, an empty cassette casing 18 is placed on the working table 16b located adjacent to the discharging conveyor 14. If the charging conveyor 13 is operated to draw out a desired one of the workpieces 17 from the cassette casing 18, this workpiece 17 drawn out as above is attracted and charged into the opened container 6 by the sucker means 24 of charging arm 21. Thereafter, the container 6 is closed by means of the closure member 32 and the air contained in the closed container 6 is expelled therefrom by the nitrogen gas introduced thereinto from the deoxygenating means 35, so that there is established an atmosphere substantially free from oxygen within the container 6, and, under this atmospheric condition, when the closed container 6 is moved across over the light source 12, the light irradiates onto the adhesive agent 25 of the workpiece 17 through the light transmissive window 33, so that the adhesive agent 25 is set or hardened to reduce its adhesive force.

After the completion of this operation, the closure member 32 of the container 6 is opened, and the treated workpiece 17 is picked up and moved to the discharging conveyor 14, by being attracted by the suction operation of the sucker means 24 of the discharging arm 22, and is placed on the discharging conveyor 14 by being released from the sucking operation of the sucker means 24, and the workpiece 17 is conveyed into the empty cassette casing 18 on the working table 16b by the discharging conveyor 14 so as to be placed on the shelf thereof.

More concretely, the operation is carried out, for instance, under the condition that the slit 28 of the casing 8 for the light source 12 is about 50 mm in width, the closed container 6 is moved to pass across over the light source 12 at a speed of about 120 mm/sec., the wafer 27 of the workpiece 17 is 12.7 cm (5 inches) in diameter the light source 12 is of 80 W/cm, and the quantity of light of 230 $mW/cm^2$ is obtained at the position of the container 6. On this occasion, the workpiece 17 is exposed to the irradiation of light from the light source 12 only for about 1.4 seconds, but each chip 17a can be taken off from the substrate 26 by an extremely weak force, and there is no adhesive agent 25 remaining on the rear surface thereof, so that it is prevented from producing any unfavorable IC chip caused by adhering of the adhesive agent 25 thereto.

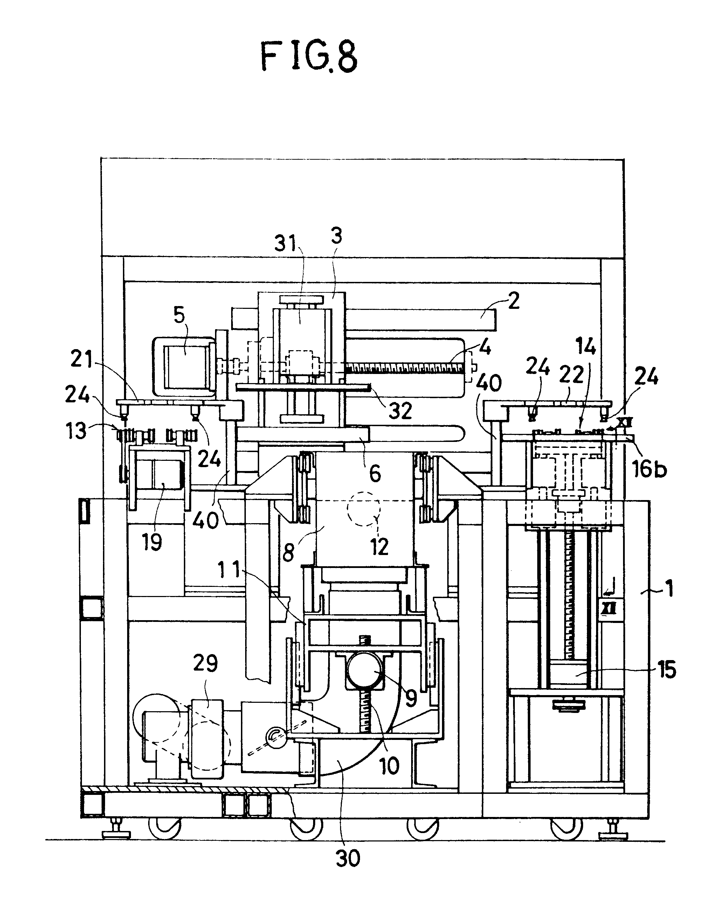

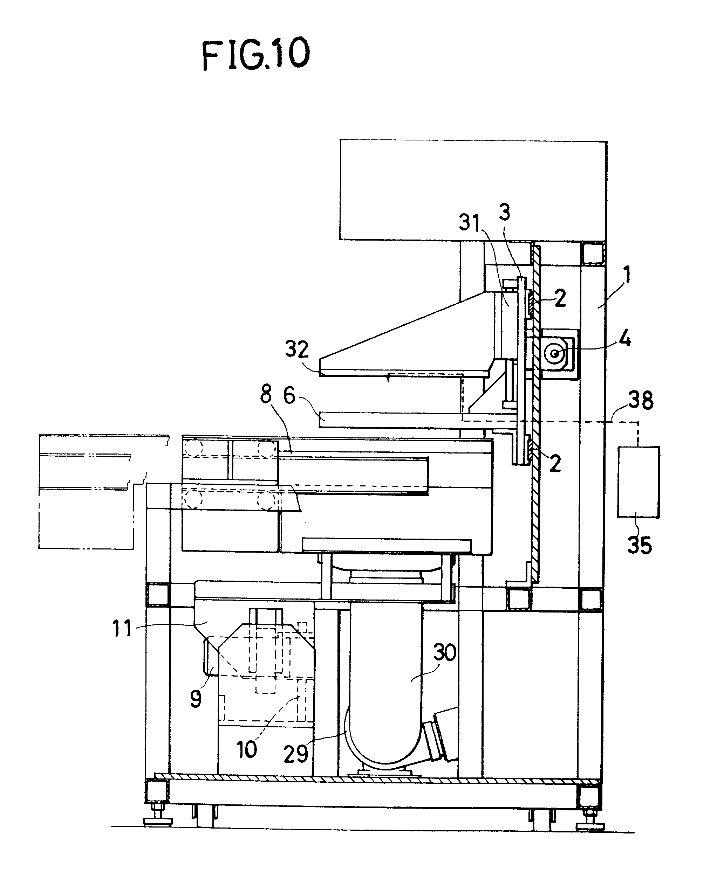

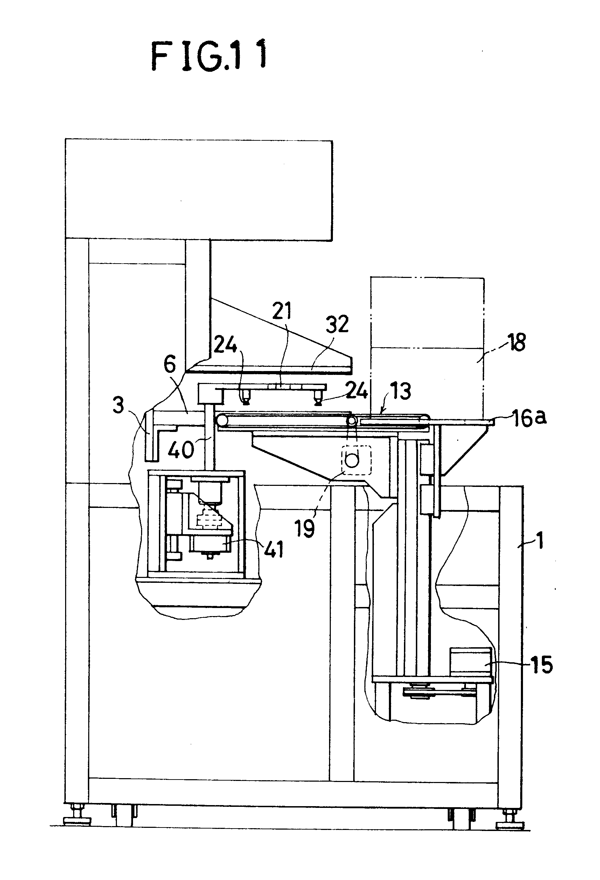

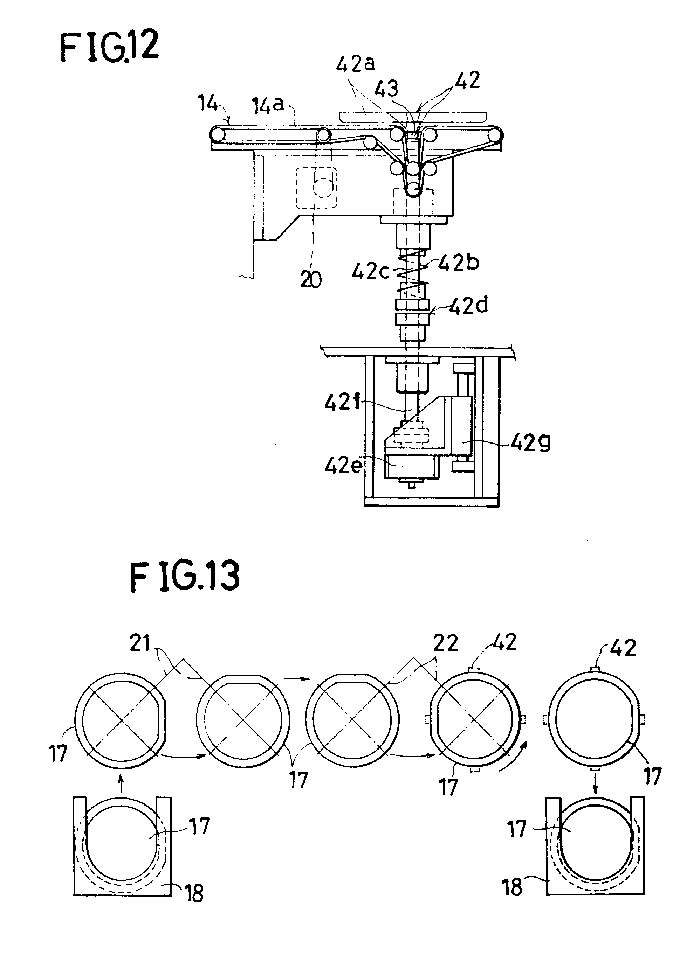

In a case where there is no space for installing the driving means for driving the charging and discharging arms 21, 22 such a construction, as shown in Figs. 8 - 12, can be considered. Namely, arms 21, 22 are attached to supporting shafts 40, 40 on the machine frame 1 on both lateral sides of the container 6 so that arms 21, 22 may be moved to swing by turning shafts 40, 40 by respective rotary actuators 41, 41. In this case, when the workpiece 17 is charged into the container 6 by swinging of the charging arm 21 and when the same is discharged therefrom by swinging of the discharging arm 22, the same is given turning angles corresponding to the swing angles of arms 21, 22 as shown in Fig. 13. When, for instance, each arm 21, 22 is 90 degrees in its turning angle, the position of the workpiece 17 is turned to its symmetrical or opposite position by an angle of 180 degrees, and if the workpiece 17 should be conveyed into the cassette casing 18 as it is at its opposite position, the relative positional relationship between the workpiece 17 and the cassette casing 18 would be changed before and after the photosetting treatment step, and consequently the quality control of the chips 17a becomes difficult. Namely, if a chip which is inferior in quality should be produced, it becomes difficult to pursue it and find the cause of the inferior quality by retracing each manufacturing step.

For eliminating the foregoing inconvenience caused by such turning of the workpiece 17, there is provided a table 42 at such a moved position of the discharging arm 22 that is just above the discharging conveyer 14 as a result of discharging the workpiece 17 from the container 6, for receiving the workpiece 17, turning it a predetermined angle and transferring it to the discharging conveyor 14, so that the discharged workpiece 17 may be turned to its initial angular position, and be conveyed into the empty cassette casing 18 as it was in its initial position.

Namely, the workpiece 17 turned by the two arms 21, 22 is received on the table 42 and is further turned by 180 degrees to its initial position by the table 42, and thereafter, the same is conveyed into the cassette casing 18 by the discharging conveyor 14, so that the relative positional relationship between the workpiece 17 and the cassette casing 18 before and after the setting treatment of the adhesive agent 25 of the workpiece 17, remains unchanged.

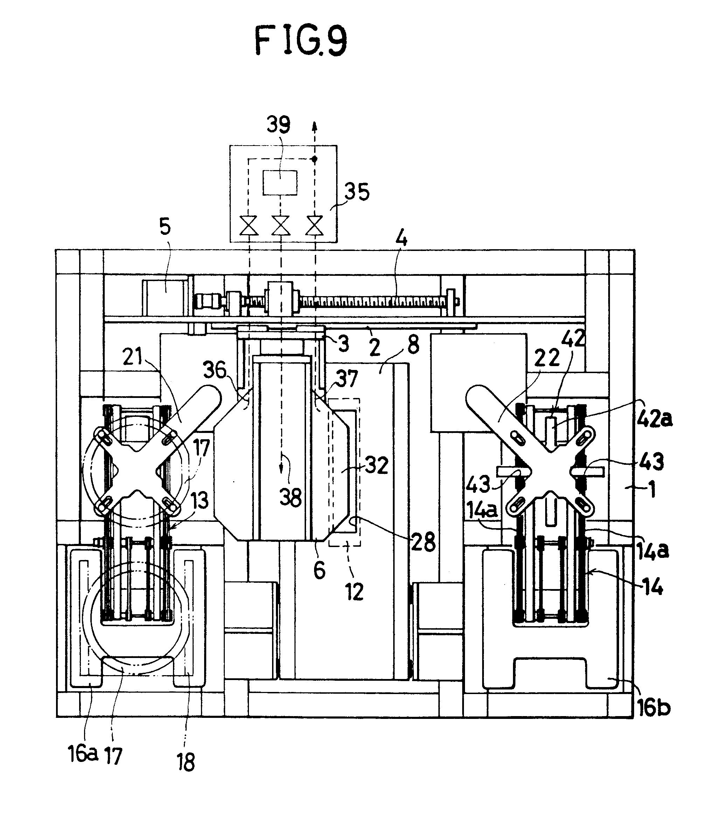

In the illustrated example, as shown in Figs. 9 and 12, left and right belts 14a, 14a constituting the discharging conveyer 14 is curved downwards, at their middle portions, to form respective spaces 43, 43, and a cross-shaped supporting base 42a constituting the table 42 is so provided as to be movable free to go into the spaces 43, 43 and out therefrom.

The table 42 is of such a construction that the supporting base 42a is attached to an upper end of an elevating rotary shaft 42c urged by a spring 42b, so that if an output shaft 42f of a rotary actuator 42e is connected thereto through a clutch 42d by an upwards movement of an air cylinder 42g, the rotary shaft $42_c$ may be given an upward movement against the action of the spring 42b and additionally a turning movement made by turning of the rotary actuator 42e may be given to the supporting base $42_a$. After the workpiece 17 is turned by 180 degrees by the two arms 21, 22 the table 42 is given a turning of 180 degrees by the rotary actuator 42e.

Thus, according to the invention, a workpiece 17 comprising a semiconductor wafer 27 adhered through an adhesive agent 25 to a substrate 26 is charged into a container 6 having a light transmissive window 33 and a closure member 32 and the air in the closed chamber thus formed is removed by a deoxygenating means 35 and under this oxygen free condition the photo-setting adhesive agent 25 is irradiated in the closed container 6 by a light, so that the adhesive force of the adhesive agent 25 is weakened in a moment or a very short time and the time for manufacturing a semiconductor can be shortened and the productivity thereof can be improved.

## Claims

1.  An apparatus for controlling the adhesive force of a photo-sensitive agent (25) adhering between a semiconductor wafer (27) and a light transmissive substrate (26) such as a light transmissive synthetic resin sheet, film or the like, forming a workpiece, characterized by
    a treating container (6) that is to be charged with the workpiece, said container (6) having a light transmissive window (33) and a closure member (32) for closing and opening said container, a light source (12) such as a mercury vapor lamp or the like located opposite to said light transmissive window (33), and
    a deaerating, deoxygenating or evacuating means (35) connected to said container (6) for removing internal atmospheric air from said container (6).

2.  The apparatus according to claim 1, characterized in that said light source (12) is elongated and that said treating container (6) is arranged to reciprocate across the front surface of a slit (28) disposed between said container (6) and said light source (12) at a right angle to the direction of movement of the container (6) and provided so as to allow the light source (12) to uniformly irradiate the workpiece (25,26,27).

## Revendications

1.  Dispositif de détermination du pouvoir collant d'un adhésif photosensible (25), adhérant entre une tranche de semi-conducteur (27) et un substrat transmettant la lumière (26), tel qu'une feuille mince, un film, en résine synthétique, transmettant la lumière, ou analogue, formant une pièce façonnée, caractérisé par un conteneur de traitement (6) dans lequel la pièce façonnée doit être chargée, ledit conteneur (6) présentant une fenêtre de transmission de la lumière (33) et un organe obturateur (32), apte à effectuer la fermeture et l'ouverture dudit conteneur, une source lumineuse (12), telle qu'une lampe à vapeur de mercure ou analogue, située à l'opposé de ladite fenêtre de transmission de lumière (33), et un moyen de désaération, de désoxygénation ou de mise sous vide (35), relié audit conteneur (6), en vue d'évacuer l'air atmosphérique interne dudit conteneur (6).

2.  Dispositif selon la revendication 1, caractérisé en ce que ladite source lumineuse (12) est allongée et que ledit conteneur de traitement (6) est agencé pour être déplacé selon un mouvement alternatif, devant la surface avant d'une fente (28) disposée entre ledit conteneur (6) et ladite source lumineuse (12), en faisant un angle droit par rapport à la direction du déplacement du conteneur (6) et de façon à permettre à la source lumineuse (12) d'illuminer uniformément la pièce façonnée (25,26,27).

## Patentansprüche

1.  Vorrichtung zur Beeinflussung der Haftkraft eines lichtempfindlichen Klebstoffs (25) der zwischen einem Halbleiter-Wafer (27) und einem lichtdurchlässigen Substrat (26), z.B. einer lichtdurchlässigen Kunstharzfolie, einem Film oder dgl., haftet, die zusammen ein Werkstück (17) bilden,
    gekennzeichnet durch
    einen mit dem Werkstück zu beladenen Behandlungsbehälter (6) mit einem lichtdurchlässigen Fenster (33) und einem Verschlußglied (32) zum Verschließen und Öffnen des Behälters,
    eine Lichtquelle (12), z.B. in Form einer Quecksilberdampflampe oder dgl., die dem lichtdurchlässigen Fenster (33) gegenüberliegt, und
    eine mit dem Behälter (6) verbundene Entlüftungs-, Deoxydations- oder Evakuierungsvorrichtung (35) zum Entfernen von innerer atmosphärischer Luft aus dem Behälter (6).

2.  Vorrichtung nach Anspruch 1, dadurch gekennzeichnet, daß die Lichtquelle (12) eine langgestreckte Form hat und daß der Behandlungsbehälter (6) so angeordnet ist, daß er quer zur Frontfläche eines Schlitzes (28) hin- und herbewegbar ist, der im rechten Winkel zur Bewegungsrichtung des Behälters (6) angeordnet ist, so daß die Lichtquelle (12) das Werkstück gleichmäßig bestrahlen kann.

# FIG.1

# FIG.2

# F IG.3

# FIG.4

# FIG.5

# FIG.6

# FIG.7

# FIG.8

# FIG.9

# FIG.10

# FIG.11

# FIG.12

# FIG.13